# EUROPEAN PATENT APPLICATION

(11) **EP 4 614 231 A1**
(43) Date of publication of application: **10.09.2025**
(21) Application number: 24161452.8
(22) Date of filing: 05.03.2024
(51) Int. Cl.: G03F 7/20, G03F 9/00

(54) **OBJECTIVE LENS ARRANGEMENT**

(71) Applicant: Mycronic AB, 183 03 Täby (SE)
(72) Inventor: WALTHER, Jonas, 169 37 Solna (SE); MATTSSON, Daniel, 197 36 Bro (SE); KARAWAJCZYK, Andrzej, 117 36 Stockholm (SE); SALEN, Martin, 131 33 Nacka (SE)
(74) Representative: AWA Sweden AB

(57) **Abstract**

The present disclosure provides an objective lens arrangement (100) for projection of an optical beam. The objective lens arrangement comprises an objective lens (110) comprising a final optical component (112) configured to focus the optical beam onto a substrate (122). The objective lens arrangement further comprises a proximity sensor (130) comprising a sensor head (132), the sensor head being arranged between the objective lens and the substrate, and a processing unit (140). The processing unit is configured to determine a first distance (d1) between the sensor head and a surface of the substrate based on an input from the proximity sensor. The sensor head is mechanically attached at the final optical component.

## Description

### Technical field

The present disclosure relates to an objective lens arrangement for projecting an optical beam onto a substrate.

### Background

In optical microlithography an optical beam is focused onto a substrate using projection optics, wherein a photo-sensitive resist provided on the substrate may be exposed to the beam. Different regions of the substrate may be exposed to the beam, thereby creating a pattern. Optical microlithography can create exceedingly small patterns, down to nanometer size, and provide a precise control of the design of the pattern. It is therefore crucial that the beam is focused in the correct plane with high accuracy. The achieved performance may correlate with an accuracy in determining and compensating for deviations of a topography of the photo-sensitive resist to be exposed. For example, variations in topography may be compensated for by altering the spatial position of the projection optics of the optical system used for the exposure with respect to the photo-sensitive resist.

A sensor may be provided to determine a distance between the projection optics and a surface of the substrate. Based on the determined distance, the spatial position of the projection optics, e.g., the height of the projection optics above the substrate or distance between the projection optics and the substrate, may be dynamically adjusted, for example by a feedback system. By this, the focus can be maintained despite deviations of the topography of the photo-sensitive resist.

Furthermore, the achieved performance may also be affected by the occurrence of thermal instabilities. There are various parts within an optical microlithography system which may generate heat, and thereby cause thermal instabilities. These thermal instabilities may affect components of the projection optics, which may cause the focal plane of the projection optics to drift, thereby resulting in a degradation of the performance. In order to ensure the performance and the focus accuracy, there is a need for a reliable and effective way to account for the influence of thermal instabilities on the components of the projection optics.

### Summary

One general aim of the present disclosure is to provide a way to account for the influence of thermal instabilities or temperature changes on the projection optics in, e.g., a microlithography system. Specifically, there is a desire to provide an arrangement to detect, measure and/or determine the effects of thermal changes on the projection optics, such as changes of the spatial position of the projection optics. Furthermore, there is a desire to be able to adjust the spatial position of the projection optics in order to compensate for the effects of the thermal changes on the projection optics, for example to maintain a certain distance between the projection optics and the photo-sensitive resist.

It is therefore an object of the present invention to meet at least some of the above-mentioned goals, and to provide an improved focus accuracy or focus control and performance of a microlithography system. This and other objects are achieved by means of an objective lens arrangement and a device for projection of an optical beam as defined in the appended independent claims. Other embodiments are defined by the dependent claims.

According to a first aspect of the present disclosure, an objective lens arrangement for projection of an optical beam is provided. The objective lens arrangement comprises an objective lens including a final optical component. The final optical component is configured to focus the optical beam onto a substrate. The objective lens arrangement further comprises a proximity sensor including a sensor head. The sensor head is arranged between the objective lens and the substrate. The objective lens arrangement further comprises a processing unit configured to determine a first distance between the sensor head and a surface of the substrate, based on an input from the proximity sensor. The sensor head is mechanically attached at the final optical component.

The present disclosure relates to the idea of providing an objective lens arrangement for projecting an optical beam that may increase quality and accuracy within, e.g., optical microlithography. The present disclosure also revolves around the idea of providing a robust and effective objective lens arrangement that may improve the focus control. The objective lens arrangement may be employed in devices where optical microlithography technology is used. Optical microlithography is a process wherein an optical beam, i.e., light, is used to generate a pattern on a substrate. The substrate may be provided with a thin coating of suitable material, such as a photo-sensitive resist. Thereby, a pattern may be formed as different regions of the photo-sensitive resist are exposed to the optical beam. A process using microlithography may create features in the micrometer range or less. The term nanolithography may be used for processes that can produce features in the nanometer range. Devices that use this type of process may for example include pattern generators and mask writers. The term "lithographic process" referred to herein may for example be a process using microlithography or nanolithography.

The objective lens arrangement may be configured to project and/or focus an optical beam onto a substrate. The optical beam may comprise light with any suitable wavelength. The optical beam may originate from a light source, such as a laser source. The substrate may comprise a flat surface, sheet and/or a plate. For example, the substrate may comprise a plate. The substrate may comprise a material based on the chemical compound silica, such as, glass, Quartz, or Soda-lime glass. The substrate may be at least partially light-transmissive. At least one coating or layer may be provided on the surface of the substrate. The at least one coating or layer may comprise an opaque material, a resist and/or a pellicle. The at least one coating or layer may be a photo-sensitive resist. The at least one coating or layer may be patterned. The substrate may be arranged or placed on a movable or static substrate holder, platform, or stage.

The objective lens may comprise one or more optical components, elements, or parts. The one or more optical components may comprise lenses, mirrors, windows, optical flats, prisms, polarizers, beam-splitters, wave-plates, fiber optics and/or filters. The objective lens may comprise a housing or a cover. The one or more optical components may be arranged in the housing. The objective lens may be configured to direct, transmit, modulate and/or focus the optical beam to reach the substrate or the photo-sensitive resist. The objective lens may be configured to focus light onto and/or gather light from the substrate. The optical beam may be a laser beam. The optical beam may enter the objective lens, be transmitted through the one or more optical components comprised in the objective lens, and then projected or focused on the substrate.

The final optical component may be an optical component in the objective lens arranged closest to the substrate. The final optical component may be arranged adjacent the substrate and/or at a front end of the objective lens. The front end of the objective lens may be an end facing the substrate and/or an end arranged closest to the substrate. The final optical component may be a lens. As the final optical component is configured to focus the optical beam onto the substrate, the final optical component may at least partially determine a focus, a focal plane, or a focal point of the objective lens.

The proximity sensor may be configured to sense (or measure, detect, or determine) a presence of an object without any physical contact with the object. The proximity sensor may be configured to perform measurements related to a distance between a first object and a second object, and/or a position of a first object and a second object. The proximity sensor may be configured to determine the presence of the substrate, e.g., a proximity of the surface of the substrate to the sensor head. The proximity sensor may be configured to generate data related to the proximity of the surface of the substrate to the sensor head. The proximity sensor may be configured to generate measurement data in real time during a projection process using the objective lens arrangement.

One or more components of the proximity sensor may be arranged at, on, or near one of the components of the objective lens arrangement. At least some parts or components of the proximity sensor may be placed or arranged at a suitable position to perform desired measurements. At least one component of the proximity sensor may be arranged on or integrated in the sensor head. The objective lens arrangement may comprise at least one proximity sensor. The sensor head may form part of the proximity sensor. The sensor head may also be considered as a part of the objective lens arrangement itself.

The sensor head may be configured to let the optical beam exiting from the objective lens pass through or near the sensor head to at least partially reach the substrate. The sensor head may comprise at least one opening or hole. For example, the sensor head may comprise at least one opening wherein the at least one opening may extend, span, or propagate from a first side of the sensor head to a second side of the sensor head. For example, the sensor head may comprise an opening extending through the sensor head such that the optical beam that exits the objective lens may pass, preferably undisturbed, through the sensor head to reach the substrate. The opening may have a dimension allowing the optical (writing) beam to pass through the opening, but deflecting or blocking stray light, from the optical beam, from reaching the substrate. The opening may for example have the form of a conical cavity. The sensor head may comprise at least one inlet or outlet. An inlet or outlet arranged in or on the sensor head may form part of the proximity sensor or be related to measurements made by the proximity sensor.

The processing unit may be connected to the proximity sensor. The processing unit may be configured to process any kind of data, for example data generated by the proximity sensor. During a lithographic process, the processing unit may receive measurement data from the proximity sensor in real time and thereby perform real-time calculations or processing of the measurement data. A first distance between the sensor head and the surface of the substrate is determined by the processing unit. The first distance is determined based on an input generated by the proximity sensor, for example the input may be data related to a proximity or distance of the sensor head to the substrate. The input from the proximity sensor may be any kind of data generated by the proximity sensor. A second distance between the final optical component of the objective lens and the surface of the substrate may be determined based on the first distance. For example, as a distance between the sensor head and the final optical component may be fixed, and may be known, the second distance may be related to the first distance. The processing unit may further determine the second distance. For example, the second distance may be determined based on a known relation between the second distance and the first distance. For example, a third distance between the final optical component and the sensor head may be known. The third distance may be at least substantially constant, such that a measured change in the first distance implies a corresponding change in the second distance. Thus, any deviation of the focal plane from its ideal or preferred position may be determined or inferred based on the measured or determined first distance.

The first distance, the second distance and the third distance may be defined along a Z-direction, wherein the Z-direction may be defined as a direction from the objective lens arrangement towards the substrate. The Z-direction may be orthogonal to the plane of the substrate. The Z-direction may be defined as a direction along the optical axis of the objective lens and/or the final optical component. The sensor head may be arranged (at least partially) between the objective lens and the surface of the substrate along the Z-direction.

It may be desirable to maintain the objective lens (or the final optical component) at a certain working distance from the surface of the substrate. The working distance may be a defined, suitable, or preferred distance, which keeps the focus of the objective lens within a certain range. It may therefore be desired that the second distance corresponds to or is equal to, the working distance. To achieve a desired quality of a projection process, such as a lithographic process, the optical beam may be focused in or on a certain plane, i.e., in this case the plane of the surface of the substrate, with an accuracy of up to 20-50 nm in the Z-direction. This means that the second distance may be controlled with an accuracy of 20-50 nm.

The sensor head may be mechanically attached to or at a part which may be in contact with the final optical component. The sensor head may be attached against or towards the final optical component of the objective lens while being arranged between the objective lens and the substrate. The sensor head may be attached at, to, or against the front end of the objective lens or a housing of the objective lens. In an example, the sensor head may be mechanically attached to a structure (arrangement or part) of, e.g., the objective lens, that may be near or adjacent the final optical component.

The objective lens arrangement for projection of an optical beam according to the first aspect of the present disclosure may provide an objective lens arrangement that may detect and/or account for changes of the second distance between the final optical component and the substrate, based on a determination of the first distance. A change of the second distance may for example be caused by thermal instabilities affecting at least one component of the objective lens. For example, one or more component(s) of the objective lens may expand or contract in reaction to temperature changes. The first distance between the sensor head and the substrate may change due to thermal instabilities affecting the objective lens. For example, the objective lens, or at least one component of the objective lens, may expand as a consequence of being locally heated by a heat source. A thermal expansion of the objective lens, or at least one component of the objective lens, may for example result in the objective lens elongating toward the substrate, i.e., in the Z-direction, or expanding laterally. By this, the focal plane or focal point of the objective lens may drift off its desired or nominal position. Even if the thermal instabilities may be small, they may have a crucial impact on the focal plane of the objective lens and thereby the quality and accuracy of the projection process. By mechanically attaching the sensor head at the final optical component, a change in position of the final optical component, corresponding to a deviation of the focal plane, may result in a corresponding change in position of the sensor head. The determination of the first distance may therefore capture or detect the influence of thermal instabilities on the objective lens. Thereby, the objective lens arrangement may provide the possibility to detect drifting of the focal plane or focal point of the objective lens.

Conventionally, in prior art systems, the sensor head may be attached at an upper portion of the objective lens, at an opposite end of the objective lens to the final optical component. Thus, if the components in the objective lens were to expand or contract due to thermal changes, a position of the final optical component may change, without the position of the sensor head changing. In other words, in prior art systems, the third distance between the final optical component and the sensor head may be affected by thermal instabilities. If the third distance changes, the second distance between the final optical component of the objective lens and the surface of the substrate, may not be as accurately determined based solely on a measurement or determination of the first distance between the sensor head and the surface of the photosensitive resist.

By attaching the sensor head at the final optical component, a change in position of the final optical component may result in a corresponding change in position of the sensor head. Thus, a change in position of the final optical component may result in a change in the above-mentioned first distance, instead of the third distance. Further, a mechanical attachment arrangement for mechanically attaching the sensor head at the final optical component may be smaller and require fewer or smaller components. Thus, a mechanical attachment arrangement attaching the sensor head at the final optical component may be less sensitive to thermal instabilities than a mechanical attachment arrangement attaching the sensor head at an opposite side of the objective lens.

Attaching the sensor head at the final optical component may provide a stable mounting of the sensor head and thereby improved accuracy in determining the first distance. Furthermore, detecting a change of the first distance, may provide the possibility of correcting, compensating, or adjusting the spatial position of the objective lens to maintain a desired second distance or a certain working distance. The objective lens arrangement according to the first aspect of the present disclosure may thereby allow for dynamic detection and compensation of changes of the second distance.

According to some embodiments, the final optical component may be supported by a final component support structure. The sensor head may be mechanically attached to the final component support structure.

The final component support structure may support, mount, hold, or arrange the final optical component. The final component support structure may be comprised in the objective lens, e.g., arranged in a housing of the objective lens. The final component support structure may arrange the final optical component such that the final optical component is correctly positioned in the objective lens and/or correctly spaced from other components of the objective lens. For example, the final optical component may be partially framed by the final component support structure. The final component support structure may comprise, for example, a ring, a barrel, a collar and/or a shoulder mount, which may have a shape suited for supporting the final optical component. Depending on the properties of the final optical component, the design or shape of the final component support structure may vary. Different final component support structures may be adapted to or suited for different final optical components and their respective function or purpose. The sensor head may be attached, fastened, or fixed to the final component support structure, for example by using glue, screws, bolts, nails, or rivets. Thereby, the sensor head may be attached, with e.g., screws, to the final component support structure which in turn supports the final optical component of the objective lens which is arranged closest to the substrate. The final component support structure may comprise a metal-based material. The final component support structure may comprise a material having a similar coefficient of thermal expansion as the final optical component. For example, the final component support structure may comprise stainless steel or titanium. In an example, the final optical component may be a lens and the final component support structure may comprise a metal barrel which partly surrounds or frames the edges of the lens. The metal barrel may on one hand partly surround the lens such that an optical beam may pass through the lens, and on the other hand provide support to the lens such that the lens is correctly positioned in the objective lens. The sensor head may be attached at the lens by being fastened to or against the metal barrel supporting the lens using screws.

Attaching the sensor head to the final component support structure may provide increased stability of the attachment or mounting of the sensor head. As the sensor head may be attached to the final component support structure supporting the final optical component, the sensor head may efficiently and securely allow for detection of changes of the first distance due to thermal instabilities affecting the objective lens. For example, the sensor head may be mechanically attached to the final component support structure using screws. An objective lens arrangement with such an attachment of the sensor head may provide improved stability, and thereby less variations of the accuracy of the projection process, such as a lithographic process.

According to some embodiments, the objective lens may comprise a plurality of further optical components supported by further component support structures.

The plurality of further optical components, elements, or parts may comprise lenses, mirrors, windows, optical flats, prisms, polarizers, beam-splitters, wave-plates, fiber optics and/or filters. The optical components of the objective lens may be arranged or positioned in various configurations and/or combinations depending on application and purpose of the objective lens arrangement. The plurality of optical components of the objective lens may be arranged in a housing of the objective lens. Each one of the plurality of further optical components may be supported by a component support structure. The component support structures may support, mount, hold, or arrange the optical components. The component support structures may be comprised in the objective lens, e.g., arranged in a housing of the objective lens. The component support structures may arrange the optical components such that the optical components are correctly positioned in the objective lens and/or spaced from each other. For example, an optical component in the objective lens may be at least partially framed by a component support structure. The component support structure may comprise, for example, a ring, a barrel, a collar and/or a shoulder mount, which may have a shape suited for supporting a certain optical component. Depending on the properties of an optical component, the design or shape of the component support structure supporting that optical component may vary. Different component support structures may be adapted to or suited for different optical components and their respective function or purpose. The component support structures may be configured to position, arrange, or space the plurality of further optical components in the objective lens. The component support structures of the optical components in the objective lens may be interrelated, interconnected, or connected to each other. Hence, the optical components may be correctly positioned in the objective lens and/or correctly spaced from each other in the objective lens. The component support structures may ensure the stability of the optical components in the objective lens.

According to some embodiments, the objective lens may be a microscopic objective lens.

The objective lens may be of a type which can be used in microscopes. Thereby the objective lens may have a focus in a micrometer or nanometer range. The objective lens may be a final lens or a field lens, which are types that may be found in microlithography systems or devices, such as pattern generators or mask writers.

According to some embodiments, the proximity sensor may comprise a pneumatic proximity sensor.

A pneumatic proximity sensor may be configured to sense, measure, detect, or determine a pressure, a flow rate, a mass and/or volume of a gas, and for example determine a presence of an object based on the pressure, the flow rate, the mass and/or volume of the gas. For example, the gas may flow in or pass through a gap or a space between the sensor head or the objective lens and the surface of the photo-sensitive resist and the pneumatic proximity sensor may measure a flow rate of the gas in that gap or space. The flow rate of the gas may vary depending on a distance or proximity between the sensor head and the surface of the substrate. The pneumatic proximity sensor may include one or more components. A pneumatic proximity sensor may provide proximity measurements without affecting the surface of the substrate. For example, if the substrate comprises a photo-sensitive resist, an optical proximity sensor might interact with, or locally develop, the photo-sensitive resist. A pneumatic proximity sensor may have a reduced interaction with or effect on the surface of the substrate. Furthermore, such a sensor may provide reduced influence of or interaction with the projection of the optical beam onto the photo-sensitive resist than, e.g., an optical proximity sensor.

According to some embodiments, the pneumatic proximity sensor may comprise a gas source, a gas channel configured to direct a gas from the gas source through a gas outlet in the sensor head, and a flow rate sensor configured to measure a flow rate of the gas. The processing unit may be configured to determine the first distance between the sensor head and the surface of the substrate based on the measured flow rate of the gas.

One or more components of the pneumatic proximity sensor may be arranged or placed at various locations in and/or at different components of the objective lens arrangement. One or more components of the pneumatic proximity sensor may be arranged at other locations than that of the objective lens arrangement, for example at a part of the system or device in which the objective lens arrangement is arranged.

The gas source may for example be a pressurized reservoir of gas. The gas source may comprise a pressurized or compressed gas, such as air. The gas in the gas source may have a known or constant pressure. The gas channel may be connected to the gas source. The gas channel may comprise one or more hollow lines or pipes to direct, lead, or guide the gas from the gas source. The gas channel may supply or provide a flow of gas to one or more gas outlets in the sensor head. The sensor head may comprise one or more outlets or openings wherein one or more gas flows may be provided. For example, a gas outlet may be a nozzle. A gas outlet in the sensor head may be arranged or placed such that gas flowing out of the gas outlet flows toward the surface of the substrate. The pressurized gas in the gas source provides a flow of gas led through the gas channel to the gas outlet in the sensor head. The gas may flow out of the gas outlet into a space or gap formed between the gas outlet and the surface of the substrate, and finally spread in the surroundings of the objective lens and/or the objective lens arrangement.

The flow rate sensor may include a mass flow sensor and/or a volume flow sensor. The flow rate sensor may be configured to measure, detect, or determine a flow rate of a gas. The flow rate sensor may measure a flow rate of the gas in the gas channel and/or a flow rate of the gas in the space formed between the gas outlet and the surface of the substrate. A flow rate of the gas in the gas channel may correspond to a pressure of the gas in the gas channel. A flow rate of the gas in the space formed between the gas outlet and the surface of the substrate may correspond to a pressure of the gas in that space.

The gas source may be held at a constant pressure. As the gas from the gas source flows via the gas channel through the gas outlet provided in the sensor head, the pressure and/or flow rate of the gas may change depending on the first distance. The flow rate sensor may detect the changes in flow rate of the gas. A change of the first distance may correspond to a change of the space (and e.g., the volume of that space) between the sensor head and the surface of the substrate, and thereby a change in flow rate and/or pressure of the gas in that space or in the gas channel.

The processing unit may be configured to receive data from the pneumatic proximity sensor and/or the flow rate sensor. The processing unit may be configured to calculate or determine the first distance based on a measured flow rate of the gas and/or a pressure of the gas corresponding to a measured flow rate of the gas.

The pneumatic proximity sensor may comprise one or more gas sources, one or more gas channels, and/or one or more flow rate sensors. The pneumatic proximity sensor may be of a type described in more detail in the patent application, by the same applicant, published as WO2020126981A1.

The various flow rates referred to herein may for example be pneumatic flow rates. The various pressures referred to herein may for example be pneumatic pressures.

According to some embodiments, the sensor head may comprise a plate. The plate may comprise the gas outlet.

The sensor head may comprise a plate and/or a flat surface. The plate may be parallel or aligned with the plane of the substrate. A surface of the plate may face the substrate. The plate comprised in the sensor head may be referred to as a focus plate, a foot plate, or a sole. Such plates may be found in microlithography devices such as pattern generators or mask writers. The sensor head may comprise one or more parts or components of the pneumatic proximity sensor. One or more gas outlets of the pneumatic proximity sensor may be arranged or placed in the plate of the sensor head. A sensor head comprising a plate including a gas outlet may facilitate and improve the accuracy of measurements related to the determination of the first distance. The plate including the gas outlet may improve detection of a change of the first distance.

According to some embodiments, the final optical component may be configured to focus the optical beam onto a photo-sensitive resist (120) provided on the substrate. The surface of the substrate may be a surface of the photo-sensitive resist.

As mentioned above, in lithography processes, a substrate may be provided with a photo-sensitive resist layer. The optical beam, such as a laser beam, may be a writing beam. The projection optics may focus the optical beam onto the photo-sensitive resist. The optical beam may locally develop the photo-sensitive resist, i.e., locally change a property of the photo-sensitive resist. The projection optics may move relative to the substrate, such that different parts of the photo-sensitive resist are exposed to the optical beam.

An intensity of the optical beam may be modulated based on pattern data, such that different parts of the photo-sensitive resist are exposed to different intensities of the laser beam. Based on exposing different parts of the photo-sensitive resist differently, a pattern may be generated in the photo-sensitive resist. By processing the substrate, the pattern may then be transferred into or onto other layers of the substrate.

According to a second aspect of the present disclosure, a device for projection of an optical beam is provided. The device comprises an optical beam source, configured to generate an optical beam, an objective lens arrangement according to the first aspect of the present disclosure, and a substrate holder configured to hold a substrate. The objective lens arrangement is configured to project the optical beam onto a substrate held by the substrate holder.

The optical beam source may be a laser source configured to generate a laser beam. The device may comprise a further optical arrangement for guiding the optical beam to the objective lens arrangement, and/or modulating the optical beam. The substrate holder may be configured to arrange, place, hold, mount, or support the substrate. The substrate holder may be configured to receive a substrate on which the optical beam may be projected. The substrate holder may be movable or static. The substrate holder may be configured to move relative to the objective lens arrangement and/or the final optical component. The objective lens arrangement and/or the final optical component may be configured to move relative to the substrate holder and thereby the substrate arranged in or on the substrate holder. The substrate holder may comprise a platform or a stage. The substrate may be arranged directly on the substrate holder or indirectly on the substrate holder. The objective lens arrangement and the substrate holder may cooperate during a projection process to move relative to each other.

According to some embodiments, the device may further comprise a control system configured to focus the optical beam with respect to the substrate by adjusting a second distance between the final optical component and the surface of the substrate based on the first distance determined by the processing unit.

The control system may be connected to one or more components of the objective lens arrangement. The processing unit of the objective lens arrangement may be integrated with or in communication with the control system. During a projection process, such as a lithographic process, wherein an optical beam is projected onto the substrate by the objective lens arrangement, the control system may receive data from the processing unit in real time. The data may comprise real-time continuous feedback of the first distance between the sensor head and the surface of the substrate. The control system may control the second distance indirectly by controlling the first distance. As the first distance may vary or change, the control system may be configured to dynamically adjust the second distance between the final optical component and the surface of the substrate. The control system may be configured to perform such an adjustment based on a known relation between the second distance and the first distance. In an example, a third distance between the final optical component and the sensor head may be known. Since the control system may be configured to adjust the second distance, a certain working distance may be maintained and/or the focal plane of the objective lens may be prevented from drifting of its target position. A target first distance, corresponding to the objective lens being in its target or preferred working position, i.e., at a target second distance, may be determined or known. Thus, the second distance may be adjusted based on controlling the first distance toward the target first distance.

A control system configured to adjust the second distance based on the first distance may provide a real-time focusing function of the device for projecting an optical beam onto a substrate. Thus, a change of the first distance, for example due to components of the objective lens being influenced by a heat source, may be compensated for in real time during a projection process. A focal plane of the objective lens drifting off its nominal or target position may thereby be dynamically corrected or adjusted. This in turn may provide an improved focus accuracy and performance of the projection process.

According to some embodiments, the control system may comprise an actuator connected to an objective lens holding structure and configured to move the objective lens via the objective lens holding structure to adjust the second distance.

The objective lens holding structure may be configured to connect, mount, or attach the objective lens to a part of the device. The objective lens holding structure may be connected to a rear end of the objective lens, the rear end being opposite to the front end of the objective lens. In an example, the objective lens holding structure may comprise a flange and/or one or more threads. The objective lens may be connected, mounted, or attached in the device via the flange and/or the one or more threads. The objective lens may be interlocked with the objective lens holding structure and vice versa. The actuator may be configured to dynamically move the objective lens via the objective lens holding structure. The actuator may be configured to adjust or change a spatial position of the objective lens, and thereby a spatial position of the final optical component comprised in the objective lens and the sensor head attached at the final optical component. By this, the second distance, and thus the first distance, may be controlled or adjusted by the actuator. The actuator may be configured to continuously receive signals indicating a position, a movement and/or a displacement of the objective lens, for example from the control system.

In an example, the objective lens may be exposed to a local heat source causing the components of the objective lens to expand and the objective lens to elongate towards the surface of the substrate, that is, in the Z-direction. As a result, the first distance may decrease, which is detected by the proximity sensor of the objective lens arrangement. The control system may then adjust the second distance using the actuator. The adjustment of the second distance may be based on the change of the first distance determined by the processing unit. As the first distance decreases, the actuator may move the objective lens (including the final optical component) away from the surface of the substrate, i.e., in a negative Z-direction, to maintain a certain second distance or working distance. By this, the focal plane of the objective lens may be maintained at its nominal/target position during a lithographic process. The control system and the objective lens arrangement may provide real-time feedback, and thereby an efficient and improved focus control during lithographic processes.

According to some embodiments, the device may be a microscopic lithography device.

It is noted that other embodiments using all possible combinations of features recited in the above-described embodiments may be envisaged. Thus, the present disclosure also relates to all possible combinations of features mentioned herein.

### Brief description of drawings

Exemplifying embodiments will now be described in more detail, with reference to the following appended drawings:
Figure 1 schematically illustrates an objective lens arrangement for projection of an optical beam according to a first aspect of the present disclosure;
Figures 2A and 2B schematically illustrate cross-sections of objective lens arrangements for projection of an optical beam according to some embodiments of the present disclosure, respectively;
Figure 3 schematically illustrates a cross-section of an objective lens arrangement for projection of an optical beam according to some embodiments of the present disclosure;
Figure 4 schematically illustrates a device for projection of an optical beam according to some embodiments of the present disclosure; and
Figure 5 schematically illustrates a device for projection of an optical beam according to some embodiments of the present disclosure.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

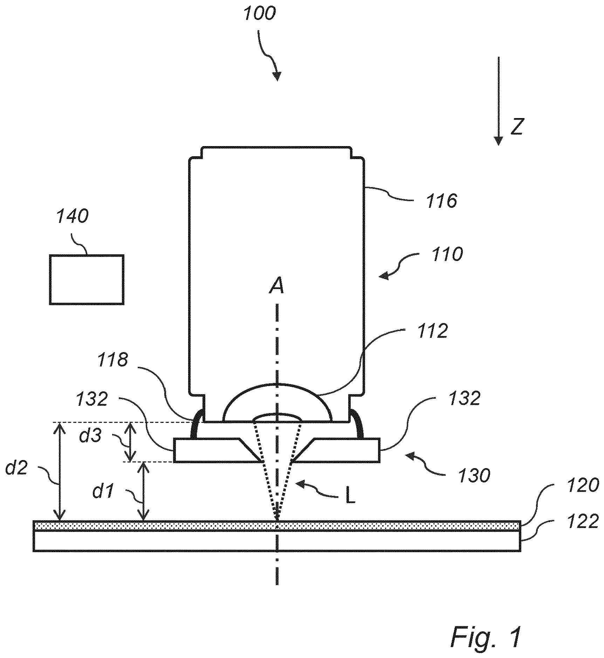

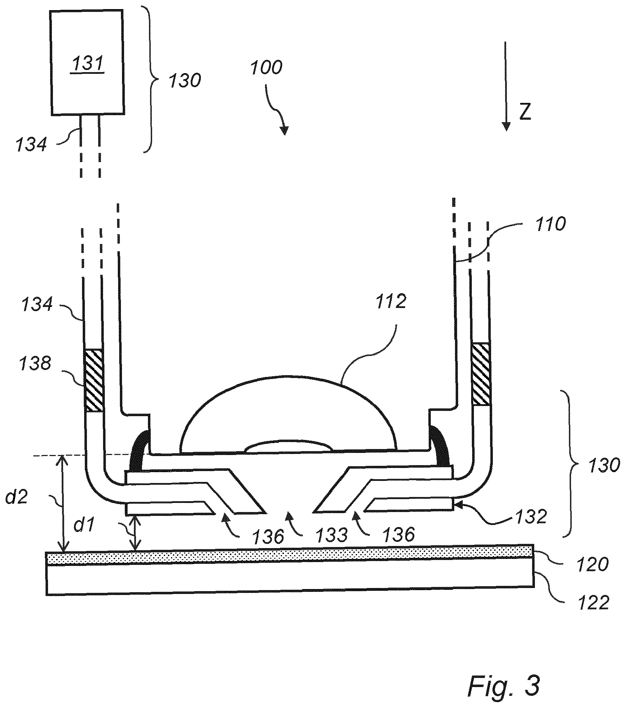

In Fig. 1, a schematic illustration of an objective lens arrangement 100 for projection of an optical beam L, according to a first aspect of the present disclosure, is shown in cross-section view. The objective lens arrangement 100 comprises an objective lens 110. The objective lens 110 comprises a final optical component 112 configured to focus the optical beam L onto a substrate 122. In Fig. 1 the optical beam L is illustrated with dotted lines from the final optical component 112 onto the surface of the photo-sensitive resist 120. The substrate 122 may be provided with at least one coating or layer of a photo-sensitive resist. As shown in Fig. 1 (and also in Figs. 3, 4, and 5) the substrate 122 is provided with one layer of a photo-sensitive resist 120. The substrate 122 may be provided with one or more coatings or layers in addition to the at least one coating or layer of a photo-sensitive resist.

The final optical component 112 is arranged at the front end of the objective lens 110. The front end of the objective lens 110 is the end arranged closest to, that is, with shortest distance to, the surface of the photo-sensitive resist 120. The front end of the objective lens 110 faces the photo-sensitive resist 120. As seen in Fig. 1, the final optical component 112 is the optical element in the objective lens 110 arranged closest to, that is, with shortest distance to, the photo-sensitive resist 120. It is envisaged that the objective lens 110 may comprise additional optical components needed to project the optical beam onto the photo-sensitive resist 120.

In Fig. 1, the objective lens 110 is illustrated with a mechanically stable housing 116 or cover in which the final optical component 112 is arranged. The final optical component 112 is illustrated as a lens in Fig. 1, however, the final optical component may be any other suitable optical element. The objective lens 110 may be a microscopic objective lens configured to focus the optical beam onto the photo-sensitive resist 120 in a micrometer or nanometer range. The objective lens 110 may be a final lens or a field lens.

A Z-direction is defined in Fig. 1 as the direction from the objective lens arrangement 100 towards the substrate 122. The Z-direction is orthogonal to the plane of the substrate 122. The Z-direction is defined as the direction along the optical axis A of the objective lens 110 and/or the final optical component 112.

The objective lens arrangement 100 comprises a proximity sensor 130. The proximity sensor comprises a sensor head 132. The proximity sensor 130 may comprise one or more parts or components, which for example may be arranged or integrated in the sensor head 132. In Fig. 1, the sensor head 132 is arranged between the objective lens 110 and the photo-sensitive resist 120 along the Z-direction. The sensor head 132 is mechanically attached, via attaching means or attaching arrangement 118, at the final optical component 112. For example, the sensor head 132 may be attached at or near the front end of the objective lens 110, e.g., to a housing 116, a component or a part of the objective lens 110. The sensor head 132 may be attached to a part which is in contact with the final optical component 112.

As seen in the cross-section view in Fig. 1, the sensor head 132 comprises an opening such that the optical beam exiting the final optical component 112, and thereby also the objective lens 110, may pass through the sensor head 132 to reach the surface of the photo-sensitive resist 120. In Fig. 1 the opening in the sensor head 132 is illustrated as a cavity having a conical or tapered shape. It is envisaged that an opening in the sensor head 132 may have other shapes than conical and that the sensor head 132 may comprise one or more openings having different shapes. The opening in the sensor head 132 may be dimensioned to accommodate the optical beam L. In an example, the sensor head 132 may comprise a circular-shaped plate comprising a circular opening. The circular opening may be centered in the circular-shaped plate and have a diameter less than the diameter of the circular-shaped plate.

In Fig. 1, the sensor head 132 is shown as a plate, however the sensor head 132 may have different shapes and designs suitable for different applications of the proximity sensor 130 and/or the objective lens arrangement 100. The proximity sensor 130 may be configured to measure or determine a proximity of the sensor head 132 to the surface of the photo-sensitive resist 120. The proximity sensor 130 may be configured to generate data indicative of or related to a first distance d1 between the sensor head 132 and the surface of the photo-sensitive resist 120. The first distance d1 between the sensor head 132 and the surface of the photo-sensitive resist 120 is defined along the Z-direction and illustrated with a double arrow in Fig. 1.

The objective lens arrangement 100 comprises a processing unit 140. In Fig. 1, the processing unit 140 is schematically illustrated at the side of the objective lens 110 and the sensor head 132. However, the processing unit 140 may for example be integrated in or arranged on the sensor head 132. The processing unit may be arranged at a part of a device (not shown) in which the objective lens arrangement arranged and used. The processing unit 140 may be connected, via cable or wirelessly, to the proximity sensor 130 and configured to receive input or data from the proximity sensor 130. The processing unit 140 is configured to determine the first distance d1 based on an input from the proximity sensor 130. The input from the proximity sensor 130 may for example be measured data related to or indicative of the distance d1 or space between the sensor head 132 and the photo-sensitive resist 120. The processing unit 140 may further be configured to determine a second distance d2 between the final optical component 112 and the surface of the photo-sensitive resist 120 based on the first distance d1. The second distance d2 between the final optical component 112 and the surface of the photo-sensitive resist 120 is defined along the Z-direction and illustrated with a double arrow in Fig. 1. The processing unit 140 may determine the second distance d2 based on the first distance d1 and known relation between the first and second distance, for example a known third distance d3 between the final optical component 112 and the sensor head 132. The third distance may be defined along the Z-direction.

In an example, the objective lens arrangement 100 may be arranged in a microlithography device (not shown). The objective lens 110 may be exposed to a heat source (not shown) locally heating one or more components of the objective lens 110. The heat source may be a part or component of the microlithography device, such as any kind of motor, or a component of the objective lens arrangement 100 that may generate heat. The objective lens 110 may, for example, elongate in the Z-direction and/or expand laterally due to thermal expansion of the components of the objective lens 110. Even if the thermal expansion may be small, it may have a crucial impact on the focal plane of the objective lens 110 and thereby the quality and accuracy of a lithographic process of the substrate. If the objective lens 110 in any way elongates in the Z-direction, the second distance d2 may decrease and the focal plane of the objective lens 110 may drift off its nominal position. Since the sensor head 132 is attached at the final optical component 112, i.e., at the front end of the objective lens 110, the first distance d1 may also decrease as the sensor head 132 moves together with the elongation or extension of the objective lens 110. The processing unit 140 may receive input from the proximity sensor 130 related to the change of the first distance d1 and determine the first distance d1. By this, a change of the second distance d2 and thereby a shift of the focal plane of the objective lens 110 may be detected and determined by the processing unit 140. The objective lens arrangement 100 therefore allows for dynamic detection and the possibility to compensate for changes of the second distance d2 and thus improved focus control.

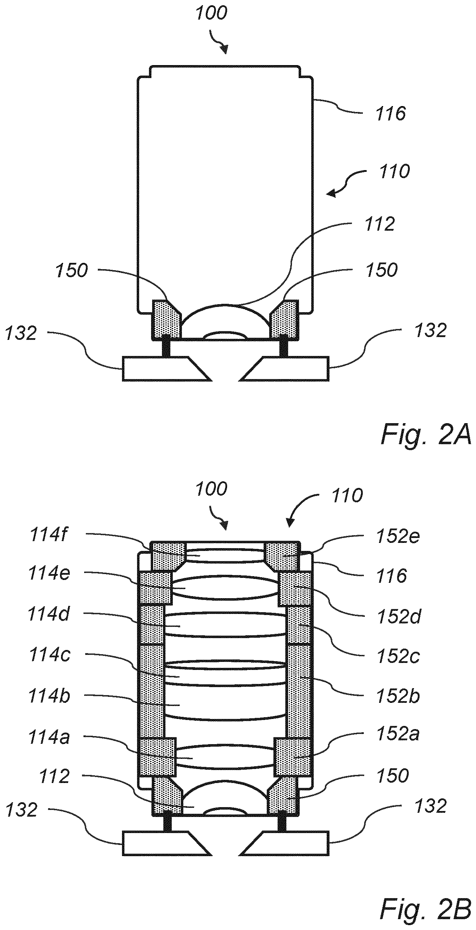

In Figs. 2A and 2B, schematic illustrations of two respective objective lens arrangements 100 for projection of an optical beam, according to some embodiments of the present disclosure, are shown in cross-section view. It should be noted that the objective lens arrangements 100 illustrated in Figs. 2A and 2B have several features in common with the objective lens arrangement 100 shown in Fig. 1. Further reference is therefore made to Fig. 1 and the associated text for an increased understanding of these features of the objective lens arrangement 100. However, for simplicity, some components of the objective lens arrangement 100 illustrated in Fig, 1 have been omitted in Figs. 2A and 2B in order to highlight certain features according to some embodiments of the present disclosure.

As illustrated in Fig. 2A, the objective lens arrangement 100 comprises a final component support structure 150 supporting the final optical component 112. The final component support structure 150 is comprised in the objective lens 110 and arranged to support the final optical component 112. The final component support structure 150 may partly surround the final optical component 112. For example, the final component support structure 150 may be a metal ring or shoulder mount arranged around the final optical component 112. Since Fig. 2A shows a cross-section of the objective lens arrangement 100, the final component support structure 150 is illustrated on the left and right side of the final optical component 112, however, the final component support structure 150 may surround the edges of the final optical component 112. The final component support structure 150 may be formed to fit the final optical component 112 and position the final optical component 112 correctly in the objective lens 110 depending on application of the objective lens arrangement 100.

As seen in Fig. 2A, the final component support structure 150 only partially covers the final optical component 112, thereby making sure that an optical beam may pass through the final optical component 112. In this way, the final optical component 112 may be sufficiently supported and an optical beam may pass through the objective lens 110 and onto the photo-sensitive resist 120. Furthermore, as shown in Fig. 2A, the sensor head 132 is mechanically attached to the final component support structure 150. The sensor head 132 may be fastened to the final component support structure 150 using for example glue, screws, or rivets. In Fig. 2A, the sensor head 132 is illustrated as spaced apart from the objective lens 110. However, this may not always be the case. The sensor head 132 may for example be attached to the final component support structure 150, or otherwise attached at the final optical component, in such a way that the sensor head 132 abuts, touches or is in contact with the objective lens 110, a housing 116 of the objective lens 110, and/or the final component support structure 150. Thus, the sensor head 132 may be attached against or towards the objective lens 110 and/or the final component support structure 150. By attaching the sensor head 132 to the final component support structure 150 an increased stability of the attachment or mounting of the sensor head 132 may be provided. With an increased stability of the sensor head 132, and efficiency or accuracy of the measurements performed in relation to the sensor head 132, such as measurements performed by the proximity sensor (not shown), may be improved.

As illustrated in Fig. 2B, the objective lens arrangement 100 comprises an objective lens 110 comprising a plurality of further optical components 114a, 114b, 114c, 114d, 114e, 114f, supported by further component support structures 152a, 152b, 152c, 152d, 152e. Fig. 2B also shows the final component support structure 150 supporting the final optical component 112 as in Fig. 2A. As illustrated in both Figs. 2A and 2B, the sensor head 132 is attached to the final component support structure 150. Fig. 2B illustrates a simplified example of an objective lens 110 comprising several optical components and several component support structures and how they may be arranged. The optical components 114a, 114b, 114c, 114d, 114e, 114f, may be lenses, mirrors, windows, optical flats, prisms, polarizers, beam-splitters, wave-plates, fiber optics and/or filters. A single optical component 114 may be supported by one component support structure 152. Alternatively, two or more optical components 114 may be supported by the same component support structure 152. As seen in Fig. 2B, the optical component 114a is supported by the component support structure 152a, and the optical components 114b and 114c are supported by the component support structure 152b. The component support structures 152a, 152b, 152c, 152d, 152e, may be metal rings, barrels or mounts, and each component support structure may be formed to support a certain optical component. The component support structures 152a, 152b, 152c, 152d, 152e, may arrange the optical components 114a, 114b, 114c, 114d, 114e, 114f, such that they are correctly positioned in the objective lens 110 and/or spaced from each other. The component support structures 152a, 152b, 152c, 152d, 152e, may be interrelated, interconnected, or connected to each other, and/or attached to the objective lens 110.

In Fig. 3, a schematic illustration of an objective lens arrangement 100 for projection of an optical beam, according to some embodiments of the present disclosure, is shown in a cross-sectional view. It is noted that the objective lens arrangements 100 illustrated in Fig. 3 has several features in common with the objective lens arrangement 100 shown in Fig. 1. Further reference is therefore made to Fig. 1 and the associated text for an increased understanding of these features. However, for simplicity, some components of the objective lens arrangement 100 illustrated in Fig 1 have been omitted in Fig. 3 in order to highlight certain features which may be implemented according to some embodiments of the present disclosure.

As illustrated in Fig. 3, the proximity sensor 130 comprises a pneumatic proximity sensor comprising a gas source 131, a gas channel 134 and a flow rate sensor 138. The proximity sensor 130 further comprises a sensor head 132 provided with a gas outlet 136. As seen in Fig. 3, the sensor head 132, the gas source 131, the gas channel 134, the gas outlet 136 and the flow rate sensor 138 may all form part of the proximity sensor 130.

In Figure 3, the proximity sensor comprises two gas channels 134, each having a flow rate sensor 138 and a gas outlet 136. The gas channels 134 may be connected to the same gas source 131. Alternatively, each of the gas channels may be connected to a separate gas source 131.

The gas source 131 may be a pressurized reservoir of gas and located some distance away from the objective lens 110 and the substrate 122. The gas source 131 may be external to the objective lens arrangement 100. The gas source 131 may comprise pressurized gas such as air.

In Fig. 3, the sensor head is illustrated as a plate. The sensor head 132 forms part of the proximity sensor 130 and includes at least a part of the gas channel 134. The gas channel 134 is connected to the gas source 131. The gas channel 134 may direct a gas from the gas source through the gas outlet 136 in the sensor head 132. The gas outlet 136 may comprise an opening, a nozzle and/or a hole in the sensor head 132. In Fig. 3, the gas outlets 136 are formed in a bottom surface of the plate of the sensor head 132, i.e., a surface facing the substrate 122. However, the gas outlet 136 may be formed differently and/or positioned elsewhere on the sensor head 132, to emit gas in a space formed between the sensor head 132, optionally the objective lens 110, and the substrate 122. For example, the gas outlet 136 may be partly formed by a cavity or a tapered opening 133 centered in the sensor head 132. For example, the gas outlet 136 may be one of a plurality of gas outlets. Pressurized gas from the gas source may create a flow of gas through the gas channel 134 and the gas outlet 136, into a space formed between the sensor head 132 and the surface of the photo-sensitive resist 120, and finally into the free space surrounding i.a. the objective lens 110.

In Fig. 3, the flow rate sensor 138 is positioned in the gas channel 134 and configured to measure a flow rate of the gas. For example, the flow rate sensor 138 may be configured to measure a flow rate of the gas flowing in the gas channel 134, or a flow rate of the gas flowing through the gas outlet 136 into the space formed between the gas outlet 136 and the surface of the photo-sensitive resist 120. As the gas source may be held at a constant pressure, the flow rate of the gas may vary depending on the proximity d1 of the surface of the photo-sensitive resist 120 and the sensor head 132. The processing unit (e.g., processing unit 140 in Fig. 1) may receive data related to a measured flow rate of the gas from the flow rate sensor 138 and determine the first distance d1 based on the data. For example, the flow rate sensor 138 may continuously or repeatedly provide a signal indicative of a measure flow rate to the processing unit. The processing unit may determine the second distance d2 based on the first distance d1.

For example, the components of the objective lens 110, e.g., the housing 116 or the component support structures 152a-e, may expand causing the objective lens 110 to elongate in the Z-direction, for example due to thermal instabilities. By this, the space formed between the sensor head 132 and the surface of the photo-sensitive resist 120 decreases. This causes the flow rate of the gas flowing through the gas outlet 136 to change. The change in flow rate is detected by the flow rate sensor 138, and the processing unit may determine the first distance d1 based on the measured change of the flow rate of the gas. Since the flow rate sensor 138 may be configured to measure a flow rate of the gas in real time, the first distance d1 may be determined in real time, for example during a projection process, that is during projection of an optical beam onto the photo-sensitive resist 120 or the substrate 122.

As mentioned above, the configuration of the components of the proximity sensor 130 is not limited to the example showed in Fig. 3. For example, the gas outlet 136 in the sensor head and/or the flow rate sensor 138 may be positioned differently in the objective lens arrangement 100 but still in a suitable way such that the proximity sensor 130 may perform necessary measurements related to the first distance d1. In another example, the proximity sensor 130 (i.e., the pneumatic proximity sensor) may comprise one or more gas outlets, one or more gas channels and/or one or more flow rate sensors.

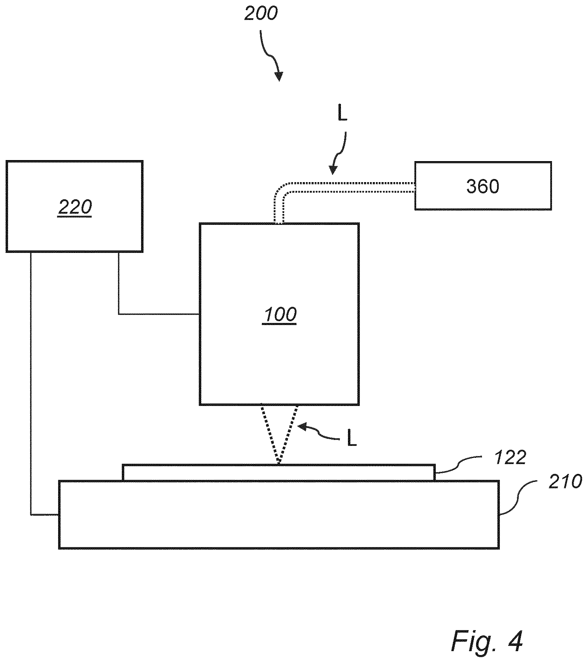

In Fig. 4, a schematic illustration of a device 200 for projection of an optical beam according to some embodiments of the present disclosure is shown.

The device 200 comprises an optical beam source 360 configured to generate an optical beam. The device 200 further comprises an objective lens arrangement 100 for projection of the optical beam L, as described above with reference to preceding figures, and a substrate holder 210. A substrate 122 is arranged or placed on the substrate holder 210. The substrate holder 210 may hold or arrange the substrate 122 such that an optical beam L may be projected onto the substrate 122.

In Fig. 4, the substrate holder 210 is illustrated as a solid object or plate and the substrate 122 is placed on top of the substrate holder 210. The substrate holder 210 may be implemented differently from what is seen in Fig. 4. For example, the substrate holder 210 may be configured to hold only the edges of the substrate 122 or the substrate holder 210 may comprise a frame in which the substrate 122 is arranged.

The substrate holder 210 and one or more components of the objective lens arrangement 100 may move relative to each other. The substrate holder 210 may be movable and configured to position the substrate 122 during a projection process.

The device 200 illustrated in Fig. 4 further comprises a control system 220 configured to focus an optical beam with respect to the photo-sensitive resist 120 by adjusting the second distance d2 (illustrated in Fig. 1 and 3) between the final optical component 112 (illustrated in Figs. 1-3) and the surface of the substrate 122 based on the first distance d1 (illustrated in in Fig. 1 and 3) determined by the processing unit 140 (illustrated in Fig. 1). The control system 220 may allow relative movement between the final optical component, including the objective lens and the sensor head not shown in Fig. 4, and the surface of the substrate 122. Phrased differently, the control system 220 may allow for control of the second distance d2 (illustrated in Fig. 1 and 3) through the first distance d1.

The control system 220 may be connected, via cable or wirelessly, to the objective lens arrangement 100 and/or the substrate holder 210 as seen in Fig. 4. The control system 220 may receive data from the processing unit of the objective lens arrangement 100, such as data related to the first distance determined by the processing unit. Based on data from the processing unit, the control system 220 may adjust or control the second distance, for example to maintain a desired working distance. In an example, the control system 220 may adjust the second distance by adjusting the spatial position of the objective lens, and the sensor head, of the objective lens arrangement 100. In another example, the control system 220 may adjust the second distance by adjusting the spatial position of the substrate holder 210 relative to the objective lens arrangement 100.

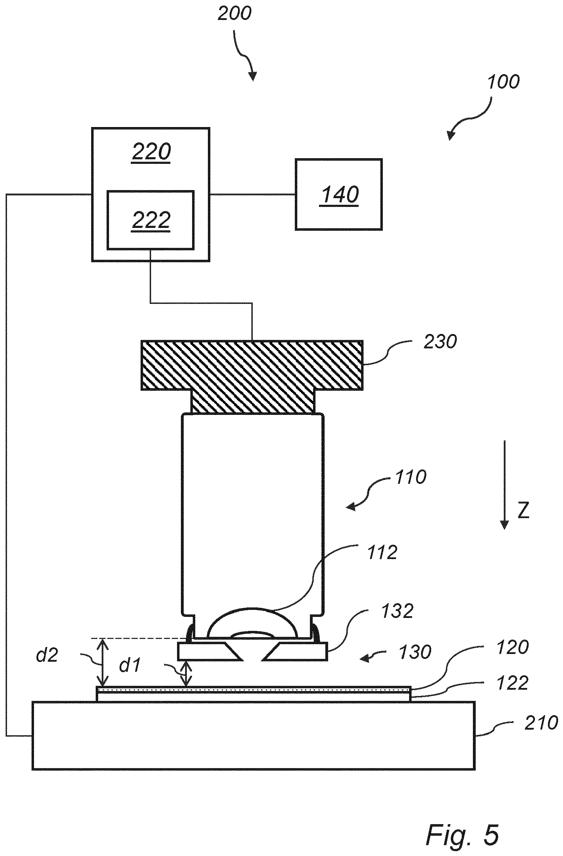

In Fig. 5, a schematic illustration of a device 200 for projection of an optical beam according to some embodiments of the present disclosure is shown.

The device 200, illustrated in Fig. 5, has several features in common with the device 200 shown in Fig. 4 and the objective lens arrangement 100 shown in Fig. 1. Further reference is therefore made to Figs. 1 and 4 and the associated text for an increased understanding of these features of the device 200 and the objective lens arrangement 100.

In Fig. 5, the device 200 comprises an objective lens arrangement 100 comprising an objective lens 110, a proximity sensor 130 and a processing unit 140.

As seen in Fig. 5, the device 200 further comprises a control system 220 comprising an actuator 222. The actuator 222 is connected to an objective lens holding structure 230. The objective lens holding structure 230 is connected to the objective lens 110. The objective lens holding structure 230 may be connected to the rear end of the objective lens 110, as illustrated in Fig. 5. The rear end of the objective lens 110 is opposite to the front end of the objective lens 110. The objective lens holding structure 230 may connect or attach the objective lens 110 to another structure (not shown) of the device 200. The objective lens holding structure 230 may for example comprise a flange or one or more threads formed to engage with the objective lens 110. Likewise, the rear end of the objective lens 110 may comprise a flange or one or more threads formed to engage with the objective lens holding structure 230. By this the objective lens holding structure 230 may be interlocked or interconnected with the objective lens 110 and vice versa.

In Fig. 5, the objective lens holding structure 230 is illustrated as a solid structure or object, however, the objective lens holding structure 230 may be formed differently. The actuator 222 may be configured to move the objective lens 110 (including the final optical component 112 and the sensor head 132) via the objective lens holding structure 230. The actuator 222 may change or adjust the spatial position of the objective lens 110 (including the final optical component 112 and the sensor head 132), for example in the Z-direction. By this, the first distance d1 and the second distance d2 may be changed by the actuator 222 as the objective lens 110 may be moved via the objective lens holding structure 230.

The processing unit 140 of the objective lens arrangement may be connected, via cable or wirelessly, to the control system 220 as seen in Fig. 5. The processing unit 140 may be integrated into the control system 220. The processing unit 140 is connected (not explicitly shown in Fig. 5) to the proximity sensor 130 and configured to receive data from the proximity sensor 130. Therefore, data related to the first distance d1 may be generated by the proximity sensor 130 and transmitted to the processing unit 140 which may determine the first distance d1 and optionally the second distance d2 based on the first distance d1.

The control system 220 may receive data comprising the determined first distance d1 and/or second distance d2 from the processing unit 140. The control system 220 may control the second distance d2 using the actuator 222 based on the determined first distance d1 and/or the second distance d2.

In an example, the objective lens 110 may be exposed to a local heat source causing the objective lens 110 to elongate towards the surface of the photo-sensitive resist 120, i.e., in the Z-direction, due to thermal expansion of the components of the objective lens 110. The first distance d1 and the second distance d2 may decrease as the objective lens 110 elongates. This may cause the focal plane of the objective lens 110 to drift off its nominal position. The proximity sensor 130 may detect the change of the first distance d1, generate data related to the first distance d1, and continuously or repeatedly feed the data to the processing unit 140. The control system 220 may continuously or repeatedly feed a control signal to the actuator 222 to move the objective lens 110 via the objective lens holding structure 230. In this example, the objective lens 110 may be moved away from the surface of the photo-sensitive resist 120, i.e., in a negative Z-direction. By this, the focal plane of the objective lens 110 may be brought back to its nominal position. Thus, an optical beam projected via the objective lens 110 onto the surface of the photo-sensitive resist 120 may be correctly focused onto the photo- sensitive resist 120 or the substrate 122.

The device 200 illustrated in Figs. 4 and 5 may be a microscopic lithography device, or a microlithography device. The components of the device 200 may cooperate to project an optical beam L onto a photo-sensitive resist 120 provided on a substrate 122 during a lithographic process and provide focus control of the optical beam L. A lithographic process in a microscopic lithography device may write, draw, or create features in a photo-sensitive resist in the micrometer scale or less. A process or device which may generate features in nanometer scale may be referred to as a nanolithography process or device.

The control system 220 of the device 200 may control the focus the optical beam with respect to the photo-sensitive resist 120 in the micrometer range. In Fig. 5, the actuator 222 may be configured to allow for movements, displacements, or positioning of the objective lens 110 via the objective lens holding structure 230 within the micrometer range. A microlithography or a nanolithography device may for example be a mask writer or a pattern generator.

The person skilled in the art realizes that the present invention by no means is limited to the preferred embodiments described above. On the contrary, many modifications and variations are possible within the scope of the appended claims.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. An objective lens arrangement (100) for projection of an optical beam, the objective lens arrangement comprising:
an objective lens (110) comprising a final optical component (112) configured to focus the optical beam onto a substrate (122);
a proximity sensor (130) comprising a sensor head (132), the sensor head being arranged between the objective lens and the substrate; and
a processing unit (140) configured to determine a first distance (d1) between the sensor head and a surface of the substrate, based on an input from the proximity sensor;
wherein the sensor head is mechanically attached at the final optical component.

2. The objective lens arrangement of claim 1, wherein:
the final optical component is supported by a final component support structure (150); and
wherein the sensor head is mechanically attached to the final component support structure.

3. The objective lens arrangement of any of the preceding claims, wherein said objective lens comprises a plurality of further optical components supported by further component support structures.

4. The objective lens arrangement of any of the preceding claims, wherein said objective lens is a microscopic objective lens.

5. The objective lens arrangement of any of the preceding claims, wherein said proximity sensor comprises a pneumatic proximity sensor.

6. The objective lens arrangement of claim 5, wherein the pneumatic proximity sensor comprises:
a gas source;
a gas channel (134) configured to direct a gas from the gas source through a gas outlet (136) in the sensor head; and
a flow rate sensor (138) configured to measure a flow rate of the gas; wherein
the processing unit is configured to determine the first distance between the sensor head and the surface of the substrate based on the measured flow rate of the gas.

7. The objective lens arrangement of claim 6, wherein the sensor head comprises a plate, and wherein the plate comprises said gas outlet.

8. The objective lens arrangement of any of the preceding claims, wherein:
the final optical component is configured to focus the optical beam onto a photo-sensitive resist (120) provided on the substrate; and
said surface of the substrate is a surface of the photo-sensitive resist.

9. A device (200) for projection of an optical beam, the device comprising:
an optical beam source (360), configured to generate an optical beam (L);
the objective lens arrangement (100) of any of the preceding claims; and
a substrate holder (210) configured to hold a substrate;
wherein the objective lens arrangement is configured to project the optical beam onto a substrate held by the substrate holder.

10. The device of claim 9, further comprising:
a control system (220) configured to focus the optical beam with respect to the substrate by adjusting a second distance (d2) between the final optical component and the surface of the substrate based on the first distance determined by the processing unit.

11. The device of claim 10, wherein said control system comprises an actuator (222) connected to an objective lens holding structure (230) and configured to move the objective lens via the objective lens holding structure to adjust the second distance.

12. The device of any of the claims 9-11, wherein said device is a microlithography device.
